(19) Europäisches Patentamt
European Patent Office
Office européen des brevets

(11) **EP 0 583 993 B1**

(12) **FASCICULE DE BREVET EUROPEEN**

(45) Date de publication et mention
de la délivrance du brevet:
**17.02.1999 Bulletin 1999/07**

(51) Int Cl.⁶: **G01R 15/00**

(21) Numéro de dépôt: **93401720.3**

(22) Date de dépôt: **02.07.1993**

(54) **Dispositif et procédé de mesure à partir du sol pour lignes aériennes à haute tension**

Mess-/Anordnung und -verfahren ab Grundniveau für Hochspannungsluftleitungen

Measuring appliance and method at earth level for high voltage air lines

(84) Etats contractants désignés:
CH DE ES FR GB IT LI SE

(30) Priorité: **06.07.1992 FR 9208311**

(43) Date de publication de la demande:
**23.02.1994 Bulletin 1994/08**

(73) Titulaire: **GEC ALSTHOM T & D SA**
**75116 Paris (FR)**

(72) Inventeurs:
• **Thuries, Edmond**
**F-69330 Meyzieu (FR)**
• **Collet, Michel**
**F-69611 Villeurbanne Cédex (FR)**

(74) Mandataire: **Gosse, Michel et al**
**ALSTOM France SA**
**Service de Propriété Industrielle**
**c/o CEGELEC**
**5, Avenue Newton**
**92142 Clamart Cédex (FR)**

(56) Documents cités:
EP-A- 0 354 079          GB-A- 2 062 251

## Description

La présente invention se rapporte à un dispositif de mesure à partir du sol de l'intensité du courant de lignes électriques aériennes à haute tension, ainsi qu'au procédé de mesure utilisant un tel dispositif.

La mesure de courant sur des lignes à haute tension aérienne nécessite l'accès aux câbles et donc des opérations de manipulation en hauteur avec un appareillage ou un engin spécial. Grâce à l'invention, il est possible de mesurer le courant à partir du niveau du sol.

Pour ce faire, le dispositif conforme à l'invention comporte pour chaque ligne au moins un appareil de détection et de mesure du champ magnétique induit par la ligne disposé sur le sol à proximité de la ligne et disposé au droit de la ligne, l'intensité du courant étant déduite par calcul.

Un dispositif de ce type est décrit dans le document de brevet GB-A-2 062 251.

Conformément à l'invention, l'appareil supporté par un châssis est logé dans un tube en matériau magnétique de forme incurvée dont l'axe est sensiblement un arc de cercle centré sur la ligne.

Grâce à ce dispositif de mesure, l'on supprime toute intervention directe sur la ligne ainsi que toute interruption de son utilisation pour l'installation ou l'entretien. De plus, il est indépendant des installations de mesure ou de protection existantes, ce qui permet de commander de manière éventuellement autonome des disjoncteurs.

L'appareil peut être un magnétomètre de n'importe quel type et en particulier un bobinage dont l'axe est disposé perpendiculairement à la ligne correspondante.

Pour améliorer l'efficacité du bobinage, un secteur magnétique en tôles feuilletées peut être placé à l'intérieur du bobinage.

De façon préférentielle, les tôles épousent la courbure des lignes de champ magnétique, afin d'agir de façon favorable sur le champ magnétique concentrique à la ligne et de façon défavorable sur les champs magnétiques provenant d'autres sources parasites.

Selon un autre mode de réalisation, le magnétomètre peut être un capteur à effet Hall situé dans un entrefer ménagé dans un secteur magnétique en tôles feuilletées.

L'invention concerne également un procédé de mesure du courant pour un ensemble de n lignes à haute tension selon lequel p appareils de détection et de mesure sont utilisés, p étant supérieur ou égal à n.

Selon un mode de réalisation préféré, en régime stable, le calcul de l'intensité est réalisé par la formule

$$Em_i = A_{ij} I_j$$

$Em_i$ étant la tension électromotrice mesurée sur l'appareil n°i, i étant compris entre 1 et p,

$I_j$ étant l'intensité du courant sur la ligne n°j, j étant compris entre 1 et n,

$A_{ij}$ étant la matrice des coefficients de proportionnalité $a_{ij}$ reliant la tension électromotrice et l'intensité du courant.

Dans le cas d'un ensemble de n lignes triphasées, une perturbation anormale est corrigée par calcul par les relations supplémentaires:

$$I_i + I_{i+1} + I_{i+2} = 0$$

i=3k-2, k étant compris entre 1 et n/3.

Eventuellement, un ensemble d'appareils de détection et de mesure du champ magnétique disposés sur le sol à des hauteurs différentes permettent de déterminer les courants de sol, leur mesure étant traitée pour tenir compte des perturbations causées par ces courants dans les mesures des appareils du dispositif de mesure.

Avantageusement, en régime transitoire, le calcul de l'intensité $i_d(t)$ du courant instantané dans la ligne n°d est réalisé par la formule

$$i_d(t) = \text{somme des parties réelles des } Id(f_k)\exp(2\pi f_k tj)$$

où

t représente le temps

j le nombre imaginaire pur dont le carré est égal à -1

$f_k$ la fréquence kième harmonique de 10Hz

$I_d(f_k)$ la composante complexe alternative de fréquence $f_k$ du courant instantané dans la ligne n°d

d étant compris entre 1 et n.

Dans ce dernier cas, de préférence, la tension est filtrée aux bornes de chaque appareil, le procédé précédemment décrit est appliqué pour chacune des fréquences harmoniques $f_k$ non nulles pour obtenir les relations reliant les composante complexes de l'intensité $I_d(fk)$ aux composantes complexes de la tension électromotrice, la sommation des intensités harmoniques est réalisé pour obtenir le courant instantané $i_d(t)$.

L'invention est exposée ci-après plus en détail à l'aide d'un dessin ne représentant qu'un mode de réalisation préféré de l'invention.

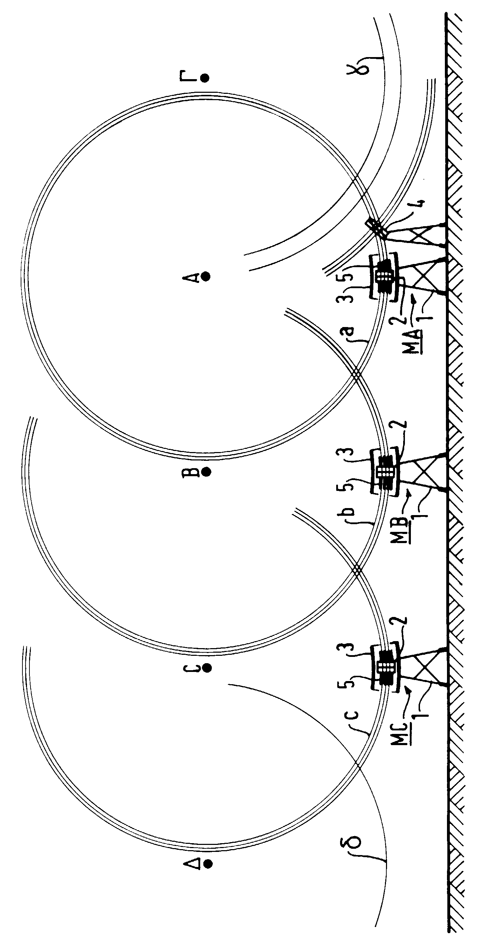

La figure représente un dispositif conforme à l'invention.

Trois lignes à haute tension aériennes A, B, C d'un sous ensemble triphasé équilibré sont disposées à proximité d'autres lignes aériennes Γ, Δ formant un sous ensemble non équilibré.

Sont disposés sur le sol à proximité de chaque ligne A, B, C dont on veut mesurer l'intensité du courant et de préférence au droit de celle-ci, au moins un châssis 1 supportant un appareil 2 de détection et de mesure du champ magnétique induit par les lignes A, B, C, l'intensité du courant étant déduite par calcul. Trois capteurs magnétomètres $M_A$, $M_B$, $M_C$ sont représentés sur la figure.

L'appareil 2 est logé dans un tube en matériau magnétique 3 de forme incurvée dont l'axe est sensiblement un arc de cercle centré sur la ligne A, B, C. C'est un bobinage dont l'axe est disposé perpendiculairement à la ligne correspondante. Un secteur magnétique 5 en tôles feuilletées est placé à l'intérieur du bobinage 2.

Ainsi, des lignes concentriques de champ magnétique induit a, b, c passent au travers de cet appareil et permettent la mesure. Le tube 3 quant à lui permet d'éviter l'interaction de champ magnétique parasite à l'endroit de l'appareil 2.

A proximité de ces trois lignes A, B, C peuvent se trouver d'autres lignes aériennes Γ, Δ dont les lignes de champ magnétique induit γ, δ interfèrent avec les lignes a, b de façon parasite. La correction nécessitée par cette interaction peut se faire par calcul comme il sera vu plus loin et/ou par mesure corrective de ces champs.

Dans ce dernier cas, au moins un second appareil 4 de détection et de mesure du champ magnétique dit de correction, de préférence de même type que le premier, est disposé à proximité des premiers appareils 2, ce second appareil 4 étant situé de façon à mesurer le champ parasite induit par la ou les ligne(s) adjacente(s) γ, δ ne faisant pas partie du sous ensemble.

Le procédé de mesure du courant conforme à l'invention va maintenant être précisé.

Pour un ensemble de n lignes à haute tension, p appareils 2 sont utilisés, c'est-à-dire sont disposés sur le sol à proximité des lignes aériennes, p étant supérieur ou égal à n.

Le courant qui circule dans une ligne aérienne provoque un flux magnétique et la variation de ce flux magnétique, en régime alternatif, provoque une tension électromotrice détectée par les appareils 2 et proportionnelle à l'intensité du courant à mesurer lorsque l'on prend la précaution de n'employer que des matériaux ayant des caractéristiques linéaires.

En régime stable, pour chacun des p appareils, les courants de toutes les n lignes participent à la création du flux magnétique mais de manière différente. Dans chaque appareil 2 la variation de ces flux magnétiques engendre une force électromotrice $Em_k$ proportionnelle aux courants $I_j$ à mesurer. Les différences de phase entre les courants $I_j$ ayant une grande importance, il est impératif de considérer les courant avec la représentation complexe comportant une partie réelle et une partie imaginaire ou en module et argument.

L'on a alors la formule

$$Em_i = A_{ij} \, I_j$$

$Em_i$ étant la tension électromotrice mesurée sur l'appareil n°i, i étant compris entre 1 et p,

$I_j$ étant l'intensité du courant sur la ligne n°j, j étant compris entre 1 et n,

$A_{ij}$ étant la matrice des coefficients de proportionnalité $a_{ij}$ reliant la tension électromotrice et l'intensité du courant.

Les coefficients $a_{ij}$ peuvent être déterminés par calcul ou mesure, lors d'essais de passage de courants d'intensité connue.

L'expression des $Em_k$ en fonction des courants se traduit par un système linéaire de p équations à n inconnues dont les coefficients dépendent des dimensions géométriques:

$$Em_1 = a_{11} I_1 + a_{12} I_2 + \ldots + a_{1n} I_n$$
$$Em_2 = a_{21} I_1 + a_{22} I_2 + \ldots + a_{2n} I_n$$
$$\ldots\ldots\ldots\ldots\ldots\ldots\ldots\ldots\ldots\ldots\ldots\ldots\ldots$$
$$Em_p = a_{p1} I_1 + a_{p2} I_2 + \ldots + a_{pn} I_n$$

Si p est strictement supérieur à n, ce système est résoluble en utilisant des méthodes de régression, qui exploitent les redondances d'informations et rendent le calcul des $I_n$ moins dépendant d'un appareil 2 défectueux ou perturbé localement. La détection d'appareil 2 perturbé peut alors donner lieu à un message au niveau d'un central de contrôle pour faire remonter l'information jusqu'aux services chargés des interventions de maintenance. De telles méthodes de régression sont par exemple décrites dans l'ouvrage "Mathematica, a system for doing mathematics by computer" de S. Wolfram, Addison-Wesley Publishing Company.

Si p est égal à n, ce système d'équations est résoluble avec une solution unique. Si ce n'est pas le cas, cela signifie que les appareils 2 sont très mal placés.

La matrice $A_{ij}$ est alors inversible et si l'on appelle sa matrice inverse $B_{pq}$, l'on obtient le système de n équations linéaires suivant:

$$I_1 = b_{11} Em_1 + b_{12} Em_2 + \ldots\ldots + b_{1n} Em_n$$
$$I_2 = b_{21} Em_1 + b_{22} Em_2 + \ldots\ldots + b_{2n} Em_n$$
$$\ldots\ldots\ldots\ldots\ldots\ldots\ldots\ldots\ldots\ldots\ldots\ldots\ldots\ldots\ldots$$
$$I_n = b_{n1} Em_1 + b_{n2} Em_2 + \ldots\ldots + b_{nn} Em_n$$

Par ailleurs, sur les lignes triphasées, la condition d'équilibre des courants en fonctionnement normal, s'exprime par

$$I_i + I_{i+1} + I_{i+2} = 0$$

i=3k-2, k étant compris entre 1 et n/3. ou

$$I_1 + I_2 + I_3 = 0$$
$$I_4 + I_5 + I_6 = 0$$
$$\ldots\ldots\ldots\ldots\ldots\ldots$$
$$I_{n-2} + I_{n-1} + I_n = 0$$

En vérifiant que ces conditions sont remplies, on peut s'assurer de la bonne utilisation des lignes.

Mais si pour des raisons d'installations, l'on est sûr que ces conditions sont toujours remplies, l'on peut alors se servir de ces relations supplémentaires pour détecter une modification éventuelle et passagère des coefficients $a_{ij}$. L'on obtient:

$$(b_{11}+b_{21}+b_{31})Em_1+(b_{12}+b_{22}+b_{32})Em_2+.+(b_{1n}+b_{2n}+b_{3n})Em_n=0$$
$$(b_{41}+b_{51}+b_{61})Em_1+(b_{42}+b_{52}+b_{62})Em_2+.+(b_{4n}+b_{5n}+b_{6n})Em_n=0$$
$$\ldots\ldots\ldots\ldots\ldots\ldots\ldots\ldots\ldots\ldots\ldots\ldots$$

En exploitant ces relations supplémentaires, il est possible de corriger une perturbation anormale localisée sur un appareil.

A proximité des postes haute tension ou dans ces postes, des courants électriques peuvent circuler dans de nombreux câbles, lignes et nappes de terre. Lors de la mesure à distance des courants électriques dans une ligne aérienne haute tension, il faut donc prendre des dispositions pour réduire à un niveau acceptable les influences de ces courants parasites. Pour ce faire, un ensemble d'appareils de détection et de mesure du champ magnétique disposés sur le sol à des hauteurs différentes permettent de déterminer les courants de sol, leur mesure étant traitée pour tenir compte des perturbations causées par ces courants dans les mesures des appareils 2 du dispositif de mesure.

Il est ainsi possible de repérer les décroissances des champs magnétiques en fonction des distances. En effet, les courants électriques dans les lignes engendrent des champs magnétiques proportionnels à 1/r, r étant la distance entre la ligne et l'appareil de détection. Les courants électriques dans le sol ou en surface qui circulent en nappe homogène sur une ou plusieurs couches engendrent au-dessus du sol un champ magnétique constant indépendant de l'élévation au-dessus du sol. Les courants électriques dans le sol qui peuvent être assimilables à des courants filiformes engendrent des champs magnétiques en 1/r.

Les valeurs des intensités et la complexité des courants électriques dans le sol, ainsi que la précision souhaitée des mesures peuvent nécessiter un nombre plus ou moins grand d'appareils de détection. Ces appareils sur différents niveaux permettent de déterminer les courants de sol de manière suffisante pour tenir compte de leurs effets et améliorer ainsi les mesures des courants de lignes aériennes. Cet agencement peut également être étendu à plusieurs plans d'appareils pour tenir compte des trois dimensions d'espace.

En régime transitoire, il faut généraliser les formules précédentes.

Pour une fenêtre temporelle $[t_1, t_2]$, telle que par exemple $t_2-t_1$ égale à 100ms, le calcul de l'intensité $i_d(t)$ du courant instantané dans la ligne n°d est réalisé par la formule

$$i_d(t) = \text{somme des } i_d(f_k, t)$$

$$= \text{somme des parties réelles des } I_d(f_k)\exp(2\pi f_k tj)$$

où

t représente le temps
j le nombre imaginaire pur dont le carré est égal à -1
$f_k$ la fréquence kième harmonique de 10Hz
$I_d(f_k)$ la composante complexe alternative de fréquence $f_k$ du courant instantané dans la ligne n°d
$i_d(f_k, t)$ la composante alternative de fréquence $f_k$ du courant $i_d(t)$ en instantanée
d étant compris entre 1 et n.

De même, l'on a

$$em_c(t) = \text{somme des } Em_c(f_k, t)$$

$$= \text{somme des parties réelles des } Em_c(f_k)\exp(2\pi f_k tj)$$

où $em_c(t)$ est la force électromotrice instantanée aux bornes de l'appareil 2 et la composante alternative de fréquence $f_k$ de la force électromotrice $em_c(t)$ est notée en instantanée $Em_c(f_k, t)$ et en complexe $Em_c(f_k)$.

Pour ce faire, la tension est filtrée aux bornes de chaque appareil 2 de manière analogique et/ou numérique et il est ainsi possible de déterminer les $Em_c(f_k)$ en module et en phase. En pratique pour des applications de protection simples ce sont les premières harmoniques qui sont intéressantes, jusqu'à des fréquences de l'ordre de 500Hz. Puis les formules précédentes sont appliquées, pour chacune des harmoniques non nulles, prises séparément, et l'on obtient les relations donnant les $I_d(f_k)$ en fonction des $Em_c(f_k)$. Par sommation de ces courants harmoniques, l'on obtient le courant instantané $i_d(t)$ à la composante continue près.

Il est à remarquer que si l'on dispose d'appareils 2 dont la mesure est directement proportionnelle au champ magnétique et non dépendante de la fréquence de ce champ en alternatif, il n'est pas nécessaire de réaliser la décomposition en fréquences harmoniques et le calcul avec les composantes complexes. Les formules précédentes sont alors directement applicables en valeurs instantanées et le traitement numérique en valeurs réelles. C'est le cas lorsqu'on utilise des capteurs à effet Hall ou des systèmes à supraconducteur. Il faut cependant dans ce cas tenir compte du champ magnétique terrestre local qui peut fausser la valeur de la composante continue.

**Revendications**

1. Dispositif de mesure du courant pour une ligne électrique aérienne (A) à haute tension comportant au moins un appareil (2) de détection et de mesure du champ magnétique induit par la ligne (A) disposé sur le sol à proximité de la ligne (A) et disposé au droit de la ligne (A), l'intensité du courant étant déduite par calcul, caractérisé en ce que l'appareil (2) supporté par un châssis (1) est logé dans un tube en matériau magnétique (3) de forme incurvée dont l'axe est sensiblement un arc de cercle centré sur la ligne (A).

2. Dispositif selon la revendication 1, caractérisé en ce que l'appareil (2) est un bobinage dont l'axe est disposé perpendiculairement à la ligne correspondante.

3. Dispositif selon la revendication 2, caractérisé en ce qu'un secteur magnétique (5) en tôles feuilletées est placé à l'intérieur du bobinage (2).

4. Dispositif selon la revendication 1, caractérisé en ce que l'appareil (2) est un capteur à effet Hall situé dans un entrefer ménagé dans un secteur magnétique en tôles feuilletées.

5. Procédé de mesure du courant pour un ensemble de n lignes à haute tension caractérisé en ce que p appareils (2) conformes à l'une des revendications précédentes sont utilisés, p étant supérieur ou égal à n.

6. Procédé de mesure du courant en régime stable selon la revendication 5, caractérisé en ce que le calcul de l'intensité est réalisé par la formule

$$Em_i = A_{ij}\, I_j$$

$Em_i$ étant la tension électromotrice mesurée sur l'appareil n°i, i étant compris entre 1 et p,
$I_j$ étant l'intensité du courant sur la ligne n°j, j étant compris entre 1 et n,
$A_{ij}$ étant la matrice des coefficients de proportionnalité $a_{ij}$ reliant la tension électromotrice et l'intensité du courant.

7. Procédé de mesure du courant pour un ensemble de n lignes triphasées selon la revendication 6, caractérisé en ce qu'une perturbation anormale est corrigée par calcul par les relations supplémentaires:

$$I_i + I_{i+1} + I_{i+2} = 0$$

i=3k-2, k étant compris entre 1 et n/3.

8. Procédé selon la revendication 6 ou 7, caractérisé en ce que un ensemble d'appareils de détection et de mesure du champ magnétique disposés sur le sol à des hauteurs différentes permettent de déterminer les courants de sol, leur mesure étant traitée pour tenir compte des perturbations causées par ces courants dans les mesures des appareils (2) du dispositif de mesure.

9. Procédé de mesure du courant en régime transitoire selon la revendication 5, caractérisé en ce que le calcul de l'intensité $i_d(t)$ du courant instantané dans la ligne n°d est réalisé par la formule

$$i_d(t) = \text{somme des parties réelles des } Id(f_k)\exp(2\pi f_k tj)$$

où

t représente le temps
j le nombre imaginaire pur dont le carré est égal à -1
$f_k$ la fréquence kième harmonique de 10Hz
$I_d(f_k)$ la composante complexe alternative de fréquence $f_k$ du courant instantané dans la ligne n°d
d étant compris entre 1 et n.

**10.** Procédé selon la revendication 9, caractérisé en ce que la tension est filtrée aux bornes de chaque appareil (2), le procédé selon la revendication 6 est appliqué pour chacune des fréquences harmoniques $f_k$ non nulles pour obtenir les relations reliant les composante complexes de l'intensité $I_d(f_k)$ aux composantes complexes de la tension électromotrice, la sommation des intensités harmoniques est réalisé pour obtenir le courant instantané $i_d(t)$.

**Patentansprüche**

**1.** Strommeßvorrichtung für eine elektrische Hochspannungs-Luftleitung (A), die wenigstens ein Gerät (2) zur Erfassung und Messung des durch die Leitung (A) induzierten magnetischen Feldes umfaßt, das auf dem Boden in der Nähe der Leitung (A) angeordnet ist und unter der Leitung (A) angeordnet ist, wobei die Stromstärke aus einer Rechnung ermittelt wird, dadurch gekennzeichnet, daß das Gerät (2), das von einem Gestell (1) getragen wird, in einer Röhre aus magnetischen Material von gebogener Form untergebracht ist, deren Achse im wesentlichen ein Kreisbogen ist, der um die Leitung (A) zentriert ist.

**2.** Vorrichtung nach Anspruch 1, dadurch gekennzeichnet, daß das Gerät (2) eine Spule ist, deren Achse im rechten Winkel zu der entsprechenden Leitung angeordnet ist.

**3.** Vorrichtung nach Anspruch 2, dadurch gekennzeichnet, daß ein magnetischer Sektor (5) aus geschichteten Blechen im Inneren der Spule (2) angebracht ist.

**4.** Vorrichtung nach Anspruch 1, dadurch gekennzeichnet, daß das Gerät (2) ein Halleffekt-Aufnehmer ist, der in einem in einem magnetischen Sektor aus geschichteten Blechen gebildeten Luftspalt angeordnet ist.

**5.** Verfahren zum Messen des Stromes für eine Gruppe von n Hochspannungsleitungen, dadurch gekennzeichnet, daß p Geräte (2) nach einem der vorhergehenden Ansprüche verwendet werden, wobei p größer oder gleich n ist.

**6.** Verfahren zum Messen des Stromes in einem stabilen Betriebszustand nach Anspruch 5, dadurch gekennzeichnet, daß die Berechnung der Stromstärke nach der Formel

$$Em_i = A_{ij}\, I_j$$

verwirklicht wird, wobei $Em_i$ die an dem Gerät n°i gemessene elektromotorische Spannung ist, wobei i zwischen 1 und p einschließlich liegt,
$I_j$ die Stärke des Stromes auf der Leitung n°j ist, wobei j zwischen 1 und n einschließlich liegt,
$A_{ij}$ die Matrix der Proportionalitätskoeffizienten $a_{ij}$ ist, die die elektromotorische Spannung und die Stromstärke verknüpfen.

**7.** Verfahren zum Messen des Stromes für eine Gruppe von n dreiphasigen Leitungen nach Anspruch 6, dadurch gekennzeichnet, daß eine anomale Störung durch eine Berechnung mit den zusätzlichen Beziehungen:

$$I_i + I_{i+1} + I_{i+2} = 0,$$

i=3k-2, korrigiert wird, wobei k zwischen 1 und n/3 einschließlich liegt.

**8.** Verfahren nach Anspruch 6 oder 7, dadurch gekennzeichnet, daß eine Gruppe von Magnetfeld-Erfassungs- und -Meßgeräten, die auf dem Boden in unterschiedlichen Höhen angeordnet sind, erlaubt, die Bodenströme zu bestimmen, wobei ihre Messung verarbeitet wird, um die Störungen zu berücksichtigen, die durch diese Ströme in den Messungen der Geräte (2) der Meßvorrichtung hervorgerufen werden.

**9.** Verfahren zum Messen des Stromes im transienten Betriebszustand nach Anspruch 5, dadurch gekennzeichnet, daß die Berechnung der Stärke $i_d(t)$ des augenblicklichen Stromes in der Leitung n°d mit der Formel

$$i_d(t) = \text{Summe der Realteile von } Id(f_k)\exp(2\pi f_k tj)$$

verwirklicht wird, wobei

t die Zeit darstellt
j die reine imaginäre Zahl ist, deren Quadrat gleich -1 ist,
$f_k$ die k-te harmonische Frequenz von 10Hz ist,
$I_d(f_k)$ die komplexe Wechselstromkomponente mit der Frequenz $f_k$ des momentanen Stromes in der Leitung n°d ist, wobei
d zwischen 1 und n einschließlich liegt.

10. Verfahren nach Anspruch 9, dadurch gekennzeichnet, daß die Spannung an den Klemmen eines jeden Gerätes (2) gefiltert wird, wobei das Verfahren nach Anspruch 6 für jede der nichtverschwindenden harmonischen Frequenzen $f_k$ angewendet wird, um die Beziehungen zu erhalten, die die komplexen Komponenten der Stromstärke $I_d(f_k)$ mit den komplexen Komponenten der elektromotorischen Spannung verknüpfen, wobei die Summe der harmonischen Stromstärken gebildet wird, um den momentanen Strom $i_d(t)$ zu erhalten.

## Claims

1. Apparatus for measuring the current in a high voltage overhead electrical line (A), characterized in that it comprises at least one device (2) for detecting and measuring the magnetic field induced by the line (A), the detector being arranged on the ground adjacent the line (A) and disposed in register with the line (A), the current being deduced by calculation, and characterized in that the device (2) supported by a framework (1) is housed in a curved tube (3) of magnetic material, the axis of which is substantially an arc of a circle centred on the line (A).

2. Apparatus according to claim 1, characterized in that the device (2) is a winding, the axis of which is perpendicular to the corresponding line.

3. Apparatus according to claim 2, characterized in that a magnetic sector (5) made up of laminations is placed inside the winding (2).

4. Apparatus according to claim 1, characterized in that the device (2) is a Hall effect sensor situated in a gap formed in a laminated magnetic sector.

5. A method for measuring the current in a group of $\underline{n}$ high voltage lines, the method being characterized in that $\underline{p}$ devices (2) conforming to any one of the preceding claims are used, $\underline{p}$ being greater than or equal to $\underline{n}$.

6. A method for measuring the current in the stable regime according to claim 5, characterized in that the current is calculated using the formula:

$$Em_i = A_{ij}I_j$$

where:

$Em_i$ is the electromotive force measured in device No.i, $\underline{i}$ lying in the range 1 to $\underline{p}$,
$I_j$ is the current in line No.j, $j$ lying in the range 1 to $\underline{n}$, and
$A_{ij}$ is the matrix of proportionality coefficients of proportionality $a_{ij}$ relating the electromotive force to the current intensity.

7. A method for measuring current for a group of $\underline{n}$ three-phase lines according to claim 6, characterized in that an abnormal perturbation is corrected by calculation using the supplementary relationships:

$$I_i + I_{i+1} + I_{i+2} = 0$$

i = 3k - 2, $\underline{k}$ lying in the range 1 to n/3.

8. A method according to claim 6 or 7, characterized in that a group of magnetic field detection and measurement devices arranged at different heights above the ground enable the ground currents to be determined, their measurements being processed to take account of the perturbations due to these currents in the measurements from the devices (2) of the measuring apparatus.

9. A method for measuring the current in the transient regime according to claim 5, characterized in that calculation of the instantaneous current $i_d(t)$ in line No.d is performed according to the formula:

$$i_d(t) = \text{sum of real parts of } Id(f_k)\exp(2\pi f_k tj)$$

where:

t represents time,
$j$ is the imaginary number whose square equals -1,
$f_k$ is the k-th harmonic of 10 Hz,
$I_d(f_k)$ is the complex alternating component at frequency $f_k$ of the instantaneous current in line No.d, and
$\underline{d}$ lies in the range 1 to $\underline{n}$,

10. A method according to claim 9, characterized in that the voltage is filtered at the terminals of each device (2), the method according to claim 6 being applied for each of the non-zero harmonic frequencies $f_k$ so as to obtain the relationships linking the complex components of the current $I_d(f_k)$ to the complex components of the electromotive voltage, the sum of the harmonic currents being calculated so as to obtain the instantaneous current $i_d(t)$.

EP 0 583 993 B1